# EUROPEAN PATENT SPECIFICATION

(11) **EP 2 341 717 B1**
(45) Date of publication and mention of the grant of the patent: **24.04.2013**
(21) Application number: 09425540.3
(22) Date of filing: 29.12.2009
(51) Int. Cl.: H04Q 9/00, H01L 31/02

(54) **System for monitoring a state of operation of a photovoltaic panel, corresponding photovoltaic system, and control method and unit for remote monitoring**
System zur Überwachung eines Betriebszustands eines photovoltaischen Kollektors, entsprechendes photovoltaisches System und Steuerungsverfahren und Steuereinheit zur Fernüberwachung
Système de surveillance de l'état de fonctionnement d'un panneau photovoltaïque, système photovoltaïque correspondant et procédé de contrôle et unité pour la surveillance à distance

(43) Date of publication of application: 06.07.2011
(73) Proprietor: SAVIO S.p.A., 10050 Chiusa San Michele (Torino) (IT)
(72) Inventor: Balbo di Vinadio, Aimone, 10050 Chiusa San Michele (Torino) (IT); Palazzetti, Mario, 10050 Chiusa San Michele (Torino) (IT)
(74) Representative: Marchitelli, Mauro

(56) References cited:
- DE-A1-102007 006 560
- DE-A1-102008 008 504
- GB-A- 2 425 884
- US-A1- 2004 211 456
- US-A1- 2009 140 719

## Description

### Background of the invention

The present invention relates to photovoltaic systems and regards a monitoring system for photovoltaic panels.

In photovoltaic systems the need is felt to have available a monitoring function that will enable identification of the panels that are not functioning or a functioning in an anomalous way in order to envisage interventions of maintenance or replacement of the panels themselves. This monitoring function is particularly important in systems having a high number of panels.

### Description of the relevant art

The document No. EP-A-2136411 describes an antitheft and monitoring system for a plurality of photovoltaic panels, comprising a first unit designed to generate activation codes, and a plurality of second units associated to the panels, in which each of the second units is designed to inhibit operation of the respective panel in the absence of the activation code for a pre-set period.

The antitheft and monitoring system is configured for activating selectively a single panel by sending the corresponding unique activation code and detecting, via a measurement, device the voltage and current characteristics of the individual active panel. This known system hence enables identification of the panels that are not functioning or are functioning in an anomalous way.

The main drawback of this known system is the relatively high cost of the units associated to the individual panels and of the central unit that carries out monitoring.

More specifically, the present invention relates to a system for monitoring a state of operation of a photovoltaic panel according to the preamble of Claim 1, which is known, e.g. from US 2004/211456 A1.

### Summary of the invention

The object of the present invention is to provide a monitoring system for photovoltaic panels, which is simple, reliable, and inexpensive.

According to the present invention, the above purpose is achieved by a system for monitoring a state of operation of a photovoltaic panel having the characteristics forming the subject of Claim 1. The invention also regards a corresponding photovoltaic system, as well as a method and a control unit for remote monitoring of the photovoltaic system.

The claims form an integral part of the technical teaching provided herein in relation to the invention.

Various embodiments envisage a system for monitoring the state of operation of a photovoltaic panel.

In various embodiments, the system comprises a transponder, in which operation of the transponder is controlled according to the state of the photovoltaic panel.

In various embodiments, the transponder transmits an individual code in response to a signal received by an external transmitter if the photovoltaic panel is in a first state of operation. Instead, the transponder does not transmit the individual code if the photovoltaic panel is in a second state of operation.

In various embodiments, the transponder is a passive transponder; i.e., an external transmitter supplies an electromagnetic field that generates in the antenna of the transponder a current that supplies the transponder.

In various embodiments the photovoltaic panel comprises at least one bypass diode.

In various embodiments, an indicative value for biasing said bypass diode is detected, and the state of the photovoltaic panel is determined according to said value.

### Brief description of the drawings

The present invention will now be described with reference to the attached drawings, which are provided purely by way of non-limiting example, and in which:
- Figure 1 shows a typical photovoltaic system;
- Figure 2 shows a typical photovoltaic module; and
- Figures 3 and 4 show an embodiment of a system for monitoring the state of a photovoltaic panel.

### Description of a preferred embodiment

In the ensuing description, various specific details are illustrated aimed at providing an in-depth understanding of the embodiments. The embodiments can be obtained without one or more of the specific details, or with other methods, components, materials, etc. In other cases, well-known structures, materials, or operations are not illustrated or described in detail so as not to render various aspects of the embodiments obscure.

Reference to "an embodiment" or "one embodiment" in the framework of this description is aimed at indicating that a particular configuration, structure or characteristic described in relation to the embodiment is included in at least one embodiment. Hence, phrases such as "in an embodiment" or "in one embodiment" that may be present in different points of this description do not necessarily refer to one and the same embodiment. Furthermore, particular conformations, structures, or characteristics can be combined in an adequate way in one or more embodiments.

The references used herein are only adopted for reasons of convenience and hence do not define the sphere of protection or the scope of the embodiments.

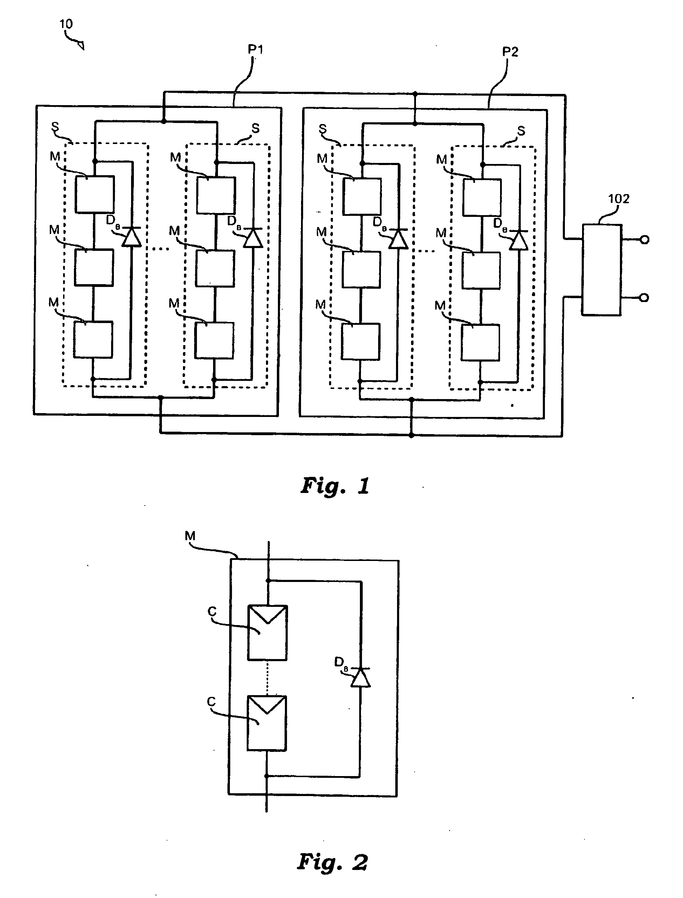

Figure 1 shows a possible embodiment of a photovoltaic system 10.

In various embodiments, the photovoltaic system comprises a converter 102 (for example a DC/AC converter) and at least one photovoltaic panel P. For example, in Figure 1 two panels P1, P2 are shown connected in parallel to one another.

In various embodiments, the photovoltaic panel P comprises at least one photovoltaic module M comprising a plurality of photovoltaic cells connected in series.

For example, in the embodiment considered always three photovoltaic modules M are connected in series to form respective strings S connected to one another in parallel. The person skilled in the art will appreciate that the number of modules that make up a string depends upon the voltage required, and the number of strings connected in parallel enables increase in the current that can be delivered.

In various embodiments, the photovoltaic panel P comprises at least one by-pass diode D_{B}. For example, in the embodiment considered, each string S has a respective by-pass diode D_{B} connected in parallel.

In various embodiments it is envisaged that connected in series to each string S is a fuse for the protection from overcurrents and/or a blocking diode to prevent a reverse current.

Figure 2 shows a possible embodiment of a module M comprising a series of photovoltaic cells C.

Also in this case a by-pass diode D_{B} may be provided connected in parallel with the series of photovoltaic cells C.

For example, the bypass diodes D_{B} prevent damage to the string S in the case of obscuration of one or more cells C. Since in the absence of direct light the photovoltaic cells C tend to turn off, reducing the conductivity of the entire series, there may occur overvoltages across the obscured cells caused by the fact that the other cells produce a voltage, whereas the obscured ones act as a load.

In the embodiment considered, to prevent damage to the latter, bypass diodes D_{B} in anti-parallel configuration are provided, which enable flow of the current hence preventing the current from passing through the obscured cell.

Hence, in various embodiments, the by-pass diode D_{B}:
a) is forward biased if the photovoltaic module P is obscured;
b) is reverse biased if the module functions correctly; and
c) is not biased if the photovoltaic system is not exposed to a solar radiation.

The inventors have noted that this behaviour can be used for determining the state of operation of the module M. In fact, the inventors have noted that the bypass diode D_{B} is also forward biased if the module M is faulty.

In various embodiments, the state of a photovoltaic panel P is hence detected as a function of a signal that is indicative for biasing of the bypass diode D_{B}.

In various embodiments, the state of a photovoltaic panel P is detected as a function of a signal identifying the voltage across the bypass diode, for example the voltage across the bypass diode and/or the current that traverses the bypass diode.

In various embodiments, a transponder is used for transmitting the state detected.

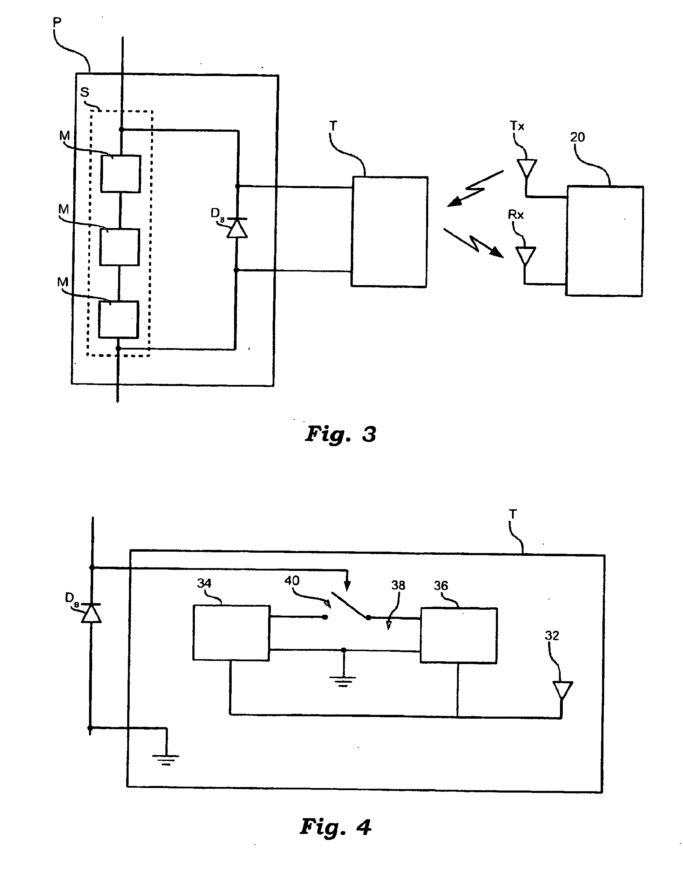

Figure 3 shows a possible embodiment of a system of the above sort for monitoring the state of a photovoltaic panel P.

In the embodiment considered, the photovoltaic panel comprises a single string S of modules M, and associated to the entire string S is a single bypass diode D_{B}.

In the embodiment considered, connected in parallel to the bypass diode D_{B} is a transponder T, which detects the state of the panel P as a function of the voltage across the bypass diode D_{B}, i.e., across the string S.

In the embodiment considered, an external control unit 20 transmits, for example via a transmission antenna Tx, a command for querying the transponder T, which responds according to the state detected. For example, the external control unit 20 can be a central unit or a palm-top.

For example, in one embodiment, the transponder T:
a) responds with its own identifier code if the panel P does not function correctly; and
b) does not respond if the panel P functions correctly, i.e., when the bypass diode D_{B} is reverse biased.

In the embodiment considered, the external control unit 20 receives, for example, via a reception antenna Rx, the response of the transponder T and displays the state of the panel P and/or undertakes other measures.

Figure 4 shows a possible embodiment of the transponder T.

In the embodiment considered, the transponder T is a passive transponder, i.e., a transponder that does not include an internal supply source but that receives the energy for the supply from the radio wave sent by the reader that queries it for being activated and retransmit the data. For example, the transponder T can be a transponder of the RFID (Radio Frequency IDentification) type.

In various embodiments, the transponder T comprises at least one antenna 32 for receiving the supply energy from the external unit 20.

In various embodiments, the transponder T also comprises a control circuit 34, for example a microchip, which has, stored inside it, an identifier code, i.e., a universal unique number. For example, in various embodiments, the control circuit 34 analyses the commands received via the antenna 32, and when a querying command is detected, the control circuit 34 transmits its identifier code. Said identifier code hence enables unique identification of the respective transponder T.

In the embodiment considered, the transponder also comprises a supply circuit 36, for example a capacitor, for generating, starting from the energy received by the antenna 32, the supply 38 for the control circuit 34.

In various embodiments, an electronic switch 40 is provided, which is controlled as a function of the state of the panel P.

For example, in the embodiment considered, the switch 40 is usually closed and is only opened if the panel P functions correctly, i.e., the bypass diode D_{B} is reverse biased. This means that the transponder is supplied and responds, if the panel P does not function correctly. However, the switch 40 remains also closed in the absence of any external supply signal across the panel P, for example if the panel P is disconnected or if all the panels connected in series are off, for instance at night.

Hence, in the embodiment considered, the transponder T:
a) does not respond when the by-pass diode D_{B} is reverse biased, i.e., when the panel is functioning;
b) responds when the by-pass diode D_{B} is forward biased, i.e., when the panel is not functioning; and
c) responds when the by-pass diode D_{B} is not biased.

This behaviour enables verification of functionality of a photovoltaic system comprising a plurality of photovoltaic panels in a few simple steps.

For instance, in a first step the responses from the transponders T of the respective panels P are verified during the day, i.e., when the system is exposed to a solar radiation. In this case, a response from a transponder T with its own identifier code indicates malfunctioning of the respective photovoltaic panel P.

Preferably, next also the responses from the transponders T of the respective panels P are verified during the night, i.e., in the absence of solar radiation. In fact, in this case, each transponder would have to respond with its own identifier code. The absence of a response from a transponder T indicates in this case malfunctioning of the respective transponder T.

For example, the person responsible for maintenance can decide to inspect the roof when the photovoltaic system manifests a poor efficiency. For instance, the efficiency of the roof 8i.e. the photovoltaic system) can be determined from the electric power measured at a counter level and from the insolation measured with a photovoltaic cell having the same plane of lie as the panels.

The various embodiments described previously hence regard a device for monitoring a photovoltaic panel. In particular, the device comprises:
- means for detecting the state of operation of the panel; and
- a transponder, which responds with its own identifier code if the panel is in a first state of operation and does not respond if the panel is in a second state of operation.

Querying may be made, for example, with a transmitting antenna Tx and a receiving antenna Rx, which operate at a relatively long distance. In the case where it is not intended to use a system of this type for reasons of costs, it is also possible to proceed with a low-power and low-cost instrument with which the person responsible for maintenance is, for example, provided, and who, when passing in the proximity of the panels, queries panel by panel.

Of course, without prejudice to the principle of the invention, the details of construction and the embodiments may vary, even significantly, with respect to what has been illustrated purely by way of nonlimiting example herein, without thereby departing from the scope of the invention, as defined by the annexed claims.

## Claims

1. A system for monitoring a state of operation of a photovoltaic panel (P), wherein said panel (P) comprises at least one photovoltaic cell (C) and one bypass diode (D_{B}) connected in anti-parallel with said at least one photovoltaic cell (C), and wherein said state of operation is determined as a function of a value identifying biasing of said bypass diode (D_{B}),
**characterized in that** said system comprises a transponder (T) for connection to said panel (P), wherein, when said panel (P) is not functioning, said transponder (T) is configured to transmit an individual identifier code in response to a pre-determined received signal and wherein, when said panel (P) is functioning, said transponder (T) is configured to not transmit said individual identifier code, and wherein said transponder (T) is configured for:
a) not transmitting said individual identifier code when the by-pass diode (D_{B}) is reverse biased;
b) transmitting said individual identifier code when the by-pass diode (D_{B}) is forward biased; and
c) transmitting said individual identifier code when the by-pass diode (D_{B}) is not biased.

2. The system according to Claim 1, wherein said value identifying biasing of said bypass diode (D_{B}) is the voltage across said bypass diode (D_{B}).

3. The system according to any one of the preceding claims, wherein the supply of said transponder is enabled (40) as a function of said state of operation of said panel (P).

4. The system according to any one of the preceding claims, wherein said transponder (T) is a passive transponder.

5. A photovoltaic system (10) comprising a plurality of photovoltaic panels (P), and wherein coupled to each photovoltaic panel (P) is a respective system for monitoring the state of operation according to any one of Claims 1 to 4.

6. A method for remote monitoring of the state of operation of a photovoltaic system (10) according to Claim 5, comprising the steps of:
a) when said system (10) is exposed to a solar radiation:
- transmitting a pre-determined signal to each transponder (T);
- detecting the response of each transponder (T), wherein each transponder (T) is configured to:
i) not respond when the respective photovoltaic panel (P) is functioning and the respective by-pass diode (D_{B}) is reverse biased,
ii) respond with a respective individual identifier code when the respective photovoltaic panel (P) is not functioning and the respective by-pass diode (D_{B}) is forward biased, and
iii) respond with said respective individual identifier code when the respective by-pass diode (D_{B}) is not biased; and
- classifying the state of operation of each panel (P) as a function of the response received from the respective transponder (T), wherein a response from a transponder (T) with its individual identifier code indicates malfunctioning of the respective photovoltaic panel (P).

7. The method according to Claim 6, comprising the steps of:
b) when said system (10) is not exposed to a solar radiation:
- transmitting said pre-determined signal to each transponder (T);
- detecting the response of each transponder (T); and
- classifying the state of operation of each transponder (T) as a function of the response received from the respective transponder (T).

8. A control unit (20) for remote monitoring of the state of operation of a photovoltaic system (10) according to Claim 5, comprising a processing unit configured for implementing the method according to Claim 6 or Claim 7.

## Patentansprüche

1. System zur Überwachung eines Betriebszustands eines Photovoltaik-Paneels (P), worin das benannte Paneel (P) mindestens eine Photovoltaik-Zelle (C) und eine Bypass-Diode (D_{B}), die antiparallel mit der benannten mindestens einen Photovoltaik-Zelle (C) verbunden ist, umfasst, und worin der benannte Betriebszustand als Funktion eines die Polarisierung der benannten Bypass-Diode (D_{B}) erkennenden Wertes bestimmt wird,
**dadurch gekennzeichnet, dass** das benannte System einen Transponder (T) zur Verbindung mit dem benannten Paneel (P) umfasst, worin, wenn das benannte Paneel (P) nicht in Betrieb ist, der benannte Transponder (T) konfiguriert ist, einen individuellen Identifizierungscode als Antwort zu einem vorgegebenen empfangenen Signal zu übertragen, und worin, wenn das benannte Paneel (P) in Betrieb ist, der benannte Transponder (T) konfiguriert ist, den benannten individuellen Identifizierungscode nicht zu übertragen, und worin der benannte Transponder (T) konfiguriert ist:
a) den benannten individuellen Identifizierungscode nicht zu übertragen, wenn die Bypass-Diode (D_{B}) in Sperrrichtung gepolt ist;
b) den benannten individuellen Identifizierungscode zu übertragen, wenn die Bypass-Diode (D_{B}) in Durchlassrichtung gepolt ist; und
c) den benannten individuellen Identifizierungscode zu übertragen, wenn die Bypass-Diode (D_{B}) nicht gepolt ist.

2. System nach Anspruch 1, worin der benannte, die Polarisierung der benannten Bypass-Diode (D_{B}) erkennende Wert die Spannung durch die benannte Bypass-Diode (D_{B}) ist.

3. System nach irgendeinem der vorherigen Ansprüche, worin die Versorgung des benannten Transponders als Funktion des benannten Betriebszustands des benannten Paneels (P) eingeschaltet (40) wird.

4. System nach irgendeinem der vorherigen Ansprüche, worin der benannte Transponder (T) ein passiver Transponder ist.

5. Photovoltaik-System (10) umfassend eine Vielzahl von Photovoltaik-Paneelen (P), und worin ein entsprechendes System zur Überwachung des Betriebszustands nach irgendeinem der Ansprüche 1 bis 4 mit jedem Photovoltaik-Paneel (P) gekoppelt ist.

6. Verfahren zur Fernüberwachung des Betriebszustands eines Photovoltaik-Systems (10) nach Anspruch 5, umfassend die folgenden Schritte:
a) wenn das benannte System (10) einer Sonnenstrahlung ausgesetzt ist:
- Übertragung eines vorgegebenen Signals zu jedem Transponder (T);
- Erfassung der Antwort jedes Transponders (T), worin jeder Transponder konfiguriert ist:
i) nicht zu antworten, wenn das entsprechende Photovoltaik-Paneel (P) in Betrieb ist und die entsprechende Bypass-Diode (D_{B}) in Sperrrichtung gepolt ist,
ii) mit einem entsprechenden individuellen Identifizierungscode zu antworten, wenn das entsprechende Photovoltaik-Paneel (P) nicht in Betrieb ist und die entsprechende Bypass-Diode (D_{B}) in Durchlassrichtung gepolt ist, und
c) mit dem benannten entsprechenden individuelle Identifizierungscode zu antworten, wenn die entsprechende Bypass-Diode (DB) nicht gepolt ist; und
- Klassifizierung des Betriebszustands jedes Paneels (P) als Funktion der vom entsprechenden Transponder (T) empfangenen Antwort, worin eine Antwort von einem Transponder (T) mit dessen individuellen Identifizierungscode eine Fehlfunktion des entsprechenden Photovoltaik-Paneels (P) angibt.

7. Verfahren nach Anspruch 6, umfassend die folgenden Schritte:
b) wenn das benannte System (10) einer Sonnenstrahlung nicht ausgesetzt ist:
- Übertragung des benannten vorgegebenen Signals zu jedem Transponder (T);
- Erfassung der Antwort jedes Transponders (T); und
- Klassifizierung des Betriebszustands jedes Transponders (T) als Funktion der vom entsprechenden Transponder (T) empfangenen Antwort.

8. Steuereinheit (20) zur Fernüberwachung des Betriebszustands eines Photovoltaik-Systems (10) nach Anspruch 5, umfassend eine Verarbeitungseinheit, die konfiguriert ist zur Ausführung des Verfahrens nach Anspruch 6 oder Anspruch 7.

## Revendications

1. Système pour contrôler l'état de fonctionnement d'un panneau photovoltaïque (P), où ledit panneau (P) comprend au moins une cellule photovoltaïque (C) et un diode de bypass (D_{B}) relié en antiparallèle à ladite au moins une cellule photovoltaïque (C), et où ledit état de fonctionnement est déterminé en fonction d'une valeur identifiant la polarisation dudit diode de bypass (D_{B}),
**caractérisé en ce que** ledit système comprend un transpondeur (T) apte à être relié audit panneau (P), où lorsque ledit panneau (P) n'est pas en fonction, ledit transpondeur (T) est configuré pour transmettre un code identificateur individuel en réponse à un signal préétabli reçu, et où lorsque ledit panneau (P) est en fonction, ledit transpondeur (T) est configuré pour ne pas transmettre ledit code identificateur individuel, et où ledit transpondeur (T) est configuré pour:
a) ne pas transmettre ledit code identificateur individuel lorsque le diode de bypass (D_{B}) est polarisé en inverse;
b) transmettre ledit code identificateur individuel lorsque le diode de bypass (D_{B}) est polarisé en direct; et
c) transmettre ledit code identificateur individuel lorsque le diode de bypass (D_{B}) n'est pas polarisé.

2. Système selon la revendication 1, où ladite valeur identifiant la polarisation dudit diode de bypass (D_{B}) est la tension à travers ledit diode de bypass (D_{B}).

3. Système selon une quelconque des revendications précédentes, où l'alimentation dudit transpondeur est activée (40) en réponse audit état de fonctionnement dudit panneau (P).

4. Système selon une quelconque des revendications précédentes, où ledit transpondeur (T) est un transpondeur passif.

5. Système photovoltaïque (10) comprenant une pluralité de panneaux photovoltaïques (P), et où un système respectif pour contrôler l'état de fonctionnement selon une quelconque des revendications 1 à 4 est accouplé à chaque panneau photovoltaïque (P).

6. Méthode pour contrôler à distance l'état de fonctionnement d'un système photovoltaïque (10) selon la revendication 5, comprenant les étapes suivantes:
a) lorsque ledit système (10) est exposé à une radiation solaire:
- transmission d'un signal préétabli à chaque transpondeur (T);
- détection de la réponse de chaque transpondeur (T), où chaque transpondeur (T) est configuré pour:
i) ne pas répondre lorsque le panneau photovoltaïque (P) respectif est en fonction et le diode de bypass (D_{B}) respectif est polarisé en inverse,
ii) répondre avec un code identificateur individuel respectif lorsque le panneau photovoltaïque (P) respectif n'est pas en fonction et le diode de bypass (D_{B}) respectif est polarisé en direct, et
c) répondre avec ledit code identificateur individuel respectif lorsque le diode de by-pass (D_{B}) respectif n'est pas polarisé; et
- classification de l'état de fonctionnement de chaque panneau (P) en fonction de la réponse reçue du transpondeur (T) respectif, où une réponse d'un transpondeur (T) avec son code identificateur respectif indique un mauvais fonctionnement du panneau photovoltaïque (P) respectif.

7. Méthode selon la revendication 6, comprenant les étapes suivantes:
b) lorsque ledit système (10) n'est pas exposé à une radiation solaire:
- transmission dudit signal préétabli à chaque transpondeur (T);
- détection de la réponse de chaque transpondeur (T); et
- classification de l'état de fonctionnement de chaque transpondeur (T) en fonction de la réponse reçue du transpondeur (T) respectif.

8. Unité de commande (20) pour le contrôle à distance de l'état de fonctionnement d'un système photovoltaïque (10) selon la revendication 5, comprenant une unité de traitement configurée pour mettre en oeuvre la méthode selon la revendication 6 ou la revendication 7.
